# EUROPEAN PATENT APPLICATION

(11) **EP 4 439 622 A1**
(43) Date of publication of application: **02.10.2024**
(21) Application number: 23164395.8
(22) Date of filing: 27.03.2023
(51) Int. Cl.: H01J 37/153

(54) **ELECTRON-OPTICAL PLATE**

(71) Applicant: ASML Netherlands B.V., 5500 AH Veldhoven (NL)
(72) Inventor: LOOMAN, Bram, Albertus, 5500 AH Veldhoven (NL); DE LANGEN, Johannes, Cornelis, Jacobus, 5500 AH Veldhoven (NL)
(74) Representative: ASML Netherlands B.V.

(57) **Abstract**

The present disclosure relates to a charged particle-optical plate (60) for a charged particle-optical device for projecting charged particle beams along beam paths to a sample location. The charged particle-optical plate comprises: a substrate having a crystalline structure with crystalline lines of symmetry (121, 122, 129); a plurality of channels (84) configured for passage of a plurality of beam paths of a beam grid through the substrate; and a plurality of multipoles associated with respective channels, each multipole comprising a plurality of electrodes (76) for the associated channel, wherein the electrodes are arranged such that geometrical lines of symmetry of the multipole are parallel to respective crystalline lines of symmetry of the crystalline structure.

## Description

### FIELD

The present disclosure relates to a charged particle-optical plate for manipulating one or more charged particle beams, a charged particle-optical assembly comprising the plate, a charged particle-optical stack comprising the plate, a charged particle-optical module comprising the plate, a charged particle-optical device comprising the plate, a charged particle-optical apparatus comprising the plate, and a method of manufacturing the plate.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which may be referred to as assessment apparatuses or assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface it is possible to obtain an image representing characteristics of the material structure of the surface of the sample.

Electron-optical plates for an electron-optical device may be used to control beams of electrons. An electron-optical plate defines features such as apertures that are used to influence trajectories of the electrons, such as by providing lensing effects, deflection and/or correction effects (e.g., stigmation and/or higher order). An electron-optical plate may be a multipole array in which surfaces of features in the plate comprises a plurality of electrodes which may be controlled to deflect the paths of the beams relative to each other. Various aspects of the features may affect performance of an electron-optical stack, such as shapes, sizes and/or positions of the features. Imperfections in the manufacturing process used to manufacture the features (such as unexpected structural features created during processing steps) can reduce performance of the electron-optical plate.

### SUMMARY

It is an object of the present disclosure to provide apparatus and methods that contribute to improving the electron-optical performance of electron-optical plates and electron-optical stacks and devices comprising such electron-optical plates.

According to an aspect of the invention, there is provided a charged particle-optical plate for a charged particle-optical device for projecting charged particle beams along beam paths to a sample location, the charged particle-optical plate comprising:
a substrate having a crystalline structure with crystalline lines of symmetry;
a plurality of channels configured for passage of a plurality of beam paths of a beam grid through the substrate; and
a plurality of multipoles associated with respective channels, each multipole comprising a plurality of electrodes for the associated channel, wherein the electrodes are arranged such that geometrical lines of symmetry of the multipole are parallel to respective crystalline lines of symmetry of the crystalline structure.

According to an aspect of the invention, there is provided a charged particle-optical plate for a charged particle-optical device for projecting a charged particle beam along a beam path to a sample location, the charged particle-optical plate comprising:
a substrate having a crystalline structure with crystalline lines of symmetry;
a channel configured for a beam path of charged particles through the substrate; and
a multipole associated with the channel, the multipole comprising a plurality of electrodes for the channel, wherein the electrodes are arranged such that geometrical lines of symmetry of the multipole are parallel to respective crystalline lines of symmetry of the crystalline structure.

According to an aspect of the invention, there is provided a charged particle-optical assembly comprising:
the charged particle-optical plate; and
an electrical supply configured to apply electrical potentials to the electrodes.

According to an aspect of the invention, there is provided a charged particle-optical stack comprising:
at least one of the charged particle-optical plate or at least one of the charged particle-optical assembly.

According to an aspect of the invention, there is provided a charged particle-optical module comprising at least one of the charged particle-optical plate, the charged particle-optical assembly and the charged particle-optical stack.

According to an aspect of the invention, there is provided a charged particle-optical device for projecting charged particle beams along beam paths to a sample location, the charged particle-optical device comprising at least one of the charged particle-optical plate, the charged particle-optical assembly, the charged particle-optical stack and the charged particle-optical module.

According to an aspect of the invention, there is provided a charged particle-optical apparatus comprising at least one of the charged particle-optical plate, the charged particle-optical assembly, the charged particle-optical stack, the charged particle-optical module and the charged particle-optical assembly.

According to an aspect of the invention, there is provided a method of manufacturing a charged particle-optical plate for a charged particle-optical device for projecting charged particle beams along beam paths to a sample location, the method comprising:
providing a substrate having a crystalline structure;
forming a plurality of channels for the beam paths through the substrate ; and
forming a plurality of multipoles associated with respective channels, each multipole comprising a plurality of electrodes for the associated channel, wherein the electrodes are arranged such that lines of symmetry of the multipole are parallel to respective lines of symmetry of the crystalline structure of the substrate.

According to an aspect of the invention, there is provided a method of manufacturing a charged particle-optical plate for a charged particle-optical device for projecting charged particle beams along beam paths to a sample location, the method comprising:
forming a plurality of channels for beam paths of a plurality of beams through a substrate having a crystalline structure with crystalline lines of symmetry, desirability between two major sides of the substrate; and
forming a plurality of multipoles each associated with a respective channel, each multipole comprising a plurality of electrodes for the associated channel, the multipole having a geometrical lines of symmetry of the electrodes with respect to the channel, wherein the forming the multipoles comprises positioning the electrodes with respect to the channel so that that the geometrical lines of symmetry are parallel to respective lines of symmetry of the crystalline structure of the substrate.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary electron-optical device comprising a condenser lens array, an objective lens array and a detector array.
**FIG. 4** is a schematic cross-sectional view of a portion of an objective lens array and detector array of an exemplary arrangement.
**FIG. 5** is bottom view of the portion of the detector array of **FIG. 4****.**
**FIG. 6** is a bottom view of a modified version of the portion of the objective lens array of **FIG. 4****.**
**FIG. 7** is a schematic diagram of an exemplary electron-optical device comprising an objective lens array and a beam separator.
**FIG. 8** is a diagram of a further exemplary electron-optical device.
**FIG. 9** is a schematic diagram of an exemplary electron-optical stack that may be part of the electron-optical devices of, for example, **FIG. 3****,** **7** and **8****.**
**FIG. 10** is a schematic perspective view of three plates of an exemplary electron-optical stack.
**FIG. 11** is a schematic side view showing an embodiment of circuitry at a feature of an electron-optical plate.
**FIG. 12** is a schematic plan view of an arrangement of electrodes for a multipole.
**FIG. 13** is a schematic plan view of an arrangement of electrodes for another multipole.
**FIG. 14** is a schematic plan view of an arrangement of electrodes for another multipole.
**FIG. 15** is a schematic perspective view of an exemplary electron-optical plate.
**FIG. 16** is another schematic plan view of the multipole shown in **FIG. 12****.**
**FIG. 17** is another schematic plan view of the multipole shown in **FIG. 14****.**
**FIG. 18** is a schematic plan view of an arrangement of electrodes for another multipole.
**FIG. 19** is a schematic plan view of an arrangement of electrodes for another multipole.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope (`SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

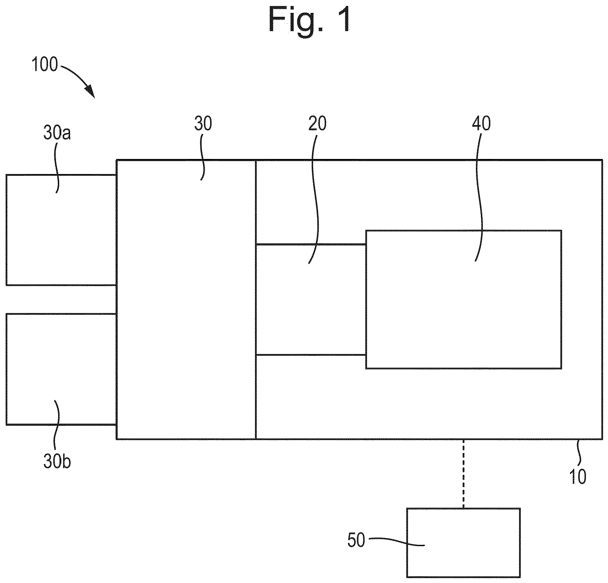

Reference is now made to **FIG. 1****,** which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical apparatus.

Controller 50 is signally, for example electronically, connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

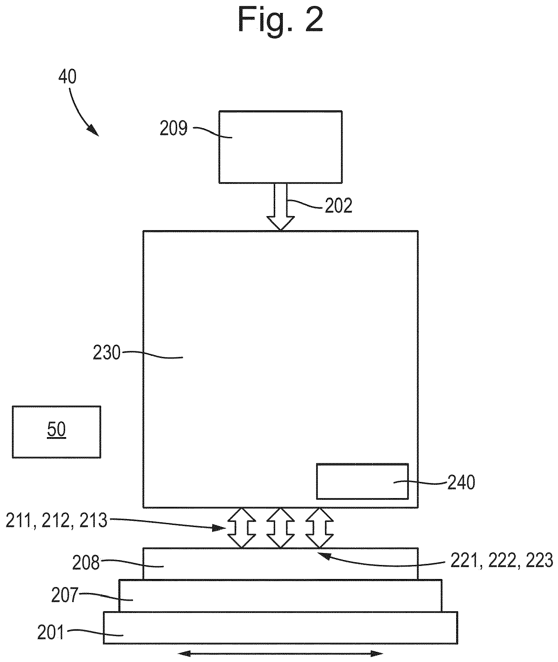

Reference is now made to **FIG. 2****,** which is a schematic diagram illustrating an exemplary electron beam apparatus 40. The electron beam apparatus 40 may be provided as part of the exemplary charged particle beam inspection system 100 of **FIG. 1****.** The electron beam apparatus 40 includes an electron source 201 and a charged particle column (or device) 230. The charged particle device 230 may be referred to or comprise a projection apparatus for directing a primary charged particle beam 202 towards a sample 208. The electron source 201 and associated and component charged particle optical elements may be referred to as an illumination apparatus for generating a primary charged particle beam 202. The apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm, for example in the range of 0.5 to 15mm.

The controller 50 (for example control system comprising distributed controllers) may be connected to various parts of charged particle beam inspection apparatus 100 of **FIG. 1****,** such as the electron source 201, the electron detection device 240, the charged particle device 230, and actuated stage 209. The controller 50 may perform various image and signal processing functions. The controller 50 may also generate various control signals to govern operations of the charged particle beam inspection apparatus 100, including operations of the electron beam apparatus 40.

The charged particle device 230 may be configured to focus, for example, beams 211, 212, and 213 onto a sample 208 for inspection and may form three probe spots 221, 222, and 223 on the surface of sample 208. The charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (≤ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, preferably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EPA 21171877.0 filed 3 May 2021 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

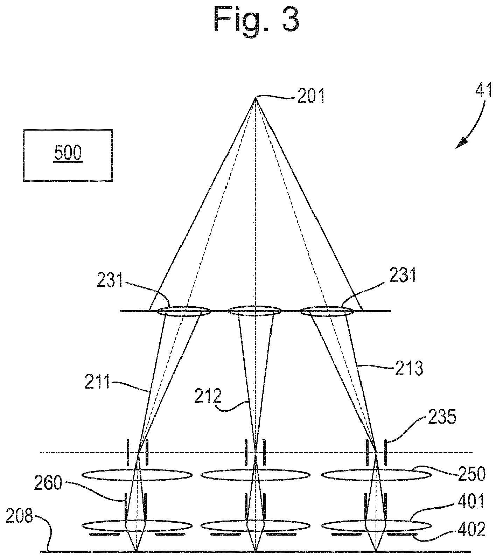

**FIG. 3** is a schematic diagram of an exemplary electron-optical device 41 (which may also be referred to as a charged particle device) for use in an assessment apparatus. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of electron-optical devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of electron-optical device 41. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators 235 may be positioned to operate on the respective intermediate focuses 233. The collimators may take the form of deflectors provided at the intermediate focuses 233. The collimators 235 may comprise a series of plates comprising electrodes arranged along the path of the beams. The collimators 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 401 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements up-beam along the primary beam path of the objective lens array 401 or even the control lens array 250. The detector module may be an array of detector elements (e.g. a detector array). Each element may be associated with an individual beam, for example positioned to detect signal particles generated by the individual beam. The detector module may comprise at least one of scintillator elements, semiconducting elements or charge capture electrodes, for example to capture signal electrons as current.

The electron-optical device 41 of **FIG. 3** may be configured to control the landing energy of electrons on the sample 208 by varying potentials applied to the electrodes of the control lenses and the objective lenses. The electrodes may comprise plates and be referred to as plates or electron-optical plates. The control lenses and objective lenses work together and may be referred to as an objective lens assembly. The landing energy can be selected to increase emission and detection of secondary electrons dependent on the nature of the sample being assessed. The detector module may be comprised in the objective lens assembly.

The objective lenses can be configured to demagnify the electron beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

In some embodiments, the objective lens array assembly comprises a detector having a detector module 402 down-beam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace a secondary column. The CMOS chip is preferably orientated to face the sample (because of the small distance between sample and the bottom of the electron-optical system, which may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g. about 100 micron). In an embodiment, electrodes to capture the signal charged particles are formed in the top metal layer of the CMOS device. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In an embodiment, a single electrode surrounds at least some of the apertures. In an arrangement a single electrode is assigned for example around each aperture. In another embodiment, a plurality of electrode elements are provided around each aperture for example as a detector element. The signal charged particles captured by the electrode elements surrounding one aperture may be combined into a single detection signal or used to generate independent detection signals. The electrode elements may be divided radially (i.e., to form a plurality of concentric annuluses), angularly (i.e., to form a plurality of sector-like pieces), both radially and angularly (providing an arrangement like a dart board), or in a grid (for example as a chess board) or in any other convenient manner.

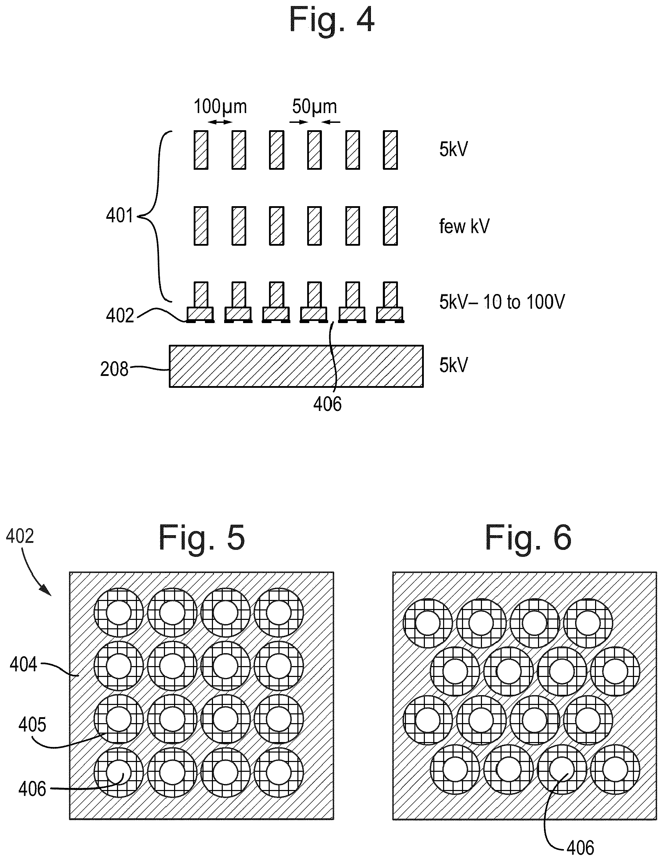

An exemplary embodiment of a detector integrated into an objective lens array 401 is shown in **FIG. 4****,** which illustrates a portion of an objective lens array 401 in schematic cross section. In this embodiment, the detector comprises a detector module 402 comprising a plurality (e.g., an array) of detector elements 405, shown in **FIG. 5** (e.g., sensor elements such as capture electrodes), preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 5** is a bottom view of detector module 402 which comprises a substrate 404 on which are provided a plurality of detector elements (or capture electrodes 405) each surrounding a beam aperture 406. The beam apertures 406 may be formed by etching through substrate 404. In the arrangement shown in **FIG. 5****,** the beam apertures 406 are shown in a rectangular array. The beam apertures 406 can also be differently arranged, e.g. in a hexagonal close packed array as depicted in

### FIG. 6.

The integrated detector module 402 described above is particularly advantageous when used with an assessment apparatus (e.g. comprising an electron-optical device) having tunable landing energy because secondary electron capture can be optimized for a range of landing energies. A detector module having or in the form of an array can also be integrated into other electrode arrays, not only the lowest electrode array. Further details and alternative arrangements of a detector module integrated into an objective lens can be found in EP Application Number 20184160.8, which document is hereby incorporated by reference.

An electric power source may be provided to apply respective potentials to electrodes of the control lenses of, for example, the control lens array 250 and the objective lenses of the objective lens array 401 and the condenser lenses of the condenser lens array or any electron-optical element or component of the electron-optical device 41 for example the detector module (such as when integrated into the objective lens array or when the objective lens and detector module are separate components). A controller 50 may control the potentials applied to the electron-optical components such as the electrodes of the condenser lens array, objective lens array and/or control lens array.

The electron-optical device 41 may comprise other electron-optical components such as charged particle correctors, for example as corrector arrays for alignment of the source to the sample and between beams of the multi-beam and for adjusting the focus of different groups of the beam grid, or individual beams of the beam grid. Such correctors may be controlled to operate dynamically and/or statically, for example during step-up, servicing or during calibration of the electron-optical device 41.

In an embodiment, an array of electron-optical devices (or device array) is provided. The array may comprise a plurality of any of the electron-optical devices (e.g., electron-optical columns or charged particle devices) described herein. Each of the electron-optical devices in the array focuses respective pluralities of charged particle beams onto different regions of the same sample 208. Each electron-optical device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different electron-optical devices simultaneously onto different regions of the same sample allows an increased area of the sample 208 to be exposed to charged particle beams simultaneously. Therefore, an increased area of the sample may be processed (e.g. assessed) at one time. The electron-optical devices in the device array may be arranged adjacent to each other so as to project the respective pluralities of beams onto adjacent regions of the sample 208. Any number of electron-optical devices may be used in the array. Preferably, the number of electron-optical devices is in the range of 9 to 200. Each electron-optical device in the device array may be configured in any of the ways described herein when referring to a single electron-optical device, charged particle device or system or column. Alternatively or additionally, one or more of the electron-optical devices in the array may be configured to project a single beam.

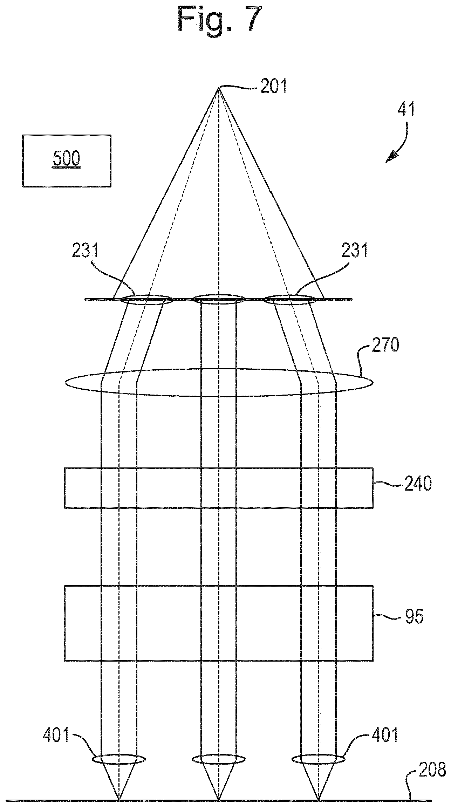

**FIG. 7** schematically depicts a further example of an electron-optical device 41. Features that are the same as those described above are given the same reference numerals. For conciseness, such features are not described in detail with reference to **FIG. 7****.** For example, the source 201, the condenser lenses 231, the objective lens array 401 and the sample 208 (e.g., on a sample support 207) may be as described above. In this example, a macro collimator 270 is provided instead of a deflector array of the type described above with reference to **FIG. 3****.** Such a macro collimator may be a macro lens that may be magnetic, electrostatic or both. In other embodiments, a deflector array may be used to at least contribute to the collimation of the beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in **FIG. 7****,** the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array 95 may be referred to as a beam separator. The deflector array 95 is configured to provide a magnetic field and an electrostatic field. The electrostatic and magnetic fields operate together to separate the charged particles projected to the sample 208 relative to the signal particles e.g. electrons from the sample 208. The operation of the fields directs the signal particles towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up beam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

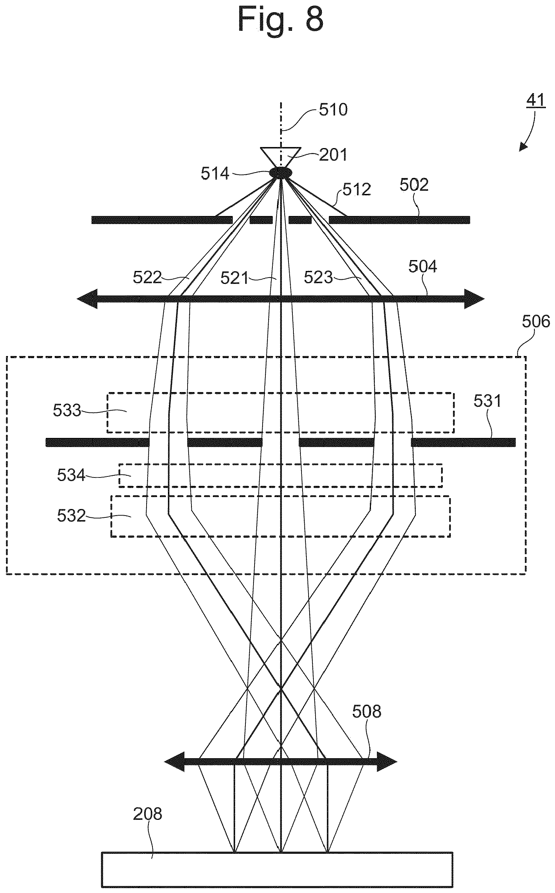

**FIG. 8** is a schematic diagram of a further exemplary electron-optical device 41 for use in an assessment apparatus. The electron-optical device 41 may be used in combination with any of the embodiments described herein, for example instead of any of the electron-optical devices 41 described above, such as with reference to **FIG. 3** and/or **FIG. 7****.** In this example, the electron-optical device 41 comprises an electron source 201, a beam-forming aperture array 502, a condenser lens 504, a source conversion unit 506, an objective lens 508, and a sample 208. The source 201 and the sample 208 may take any of the forms described above with reference for example to **FIG. 2****,** **3** and **7** for example. The source 201, beam-forming aperture array 502, condenser lens 504, source conversion unit 506, and objective lens 508 may be aligned with a primary electron-optical axis 510 of the charged particle device 41. The source 201 generates a primary electron beam 512 with a source cross-over 514. The beam-forming aperture array 502 forms beams 521, 522, 523 from the primary beam 512. A line of three beams is depicted but the beam-forming aperture array 502 may be configured to form a line of two beams or a line of more than three beams, such as a line of four beams or a line of five beams. The beam-forming aperture array 502 may also be configured to form multiple lines of beams, thereby forming an array of beams. For example, the beam-forming aperture array 502 may be configured to form an n × m array of beams where *n* and *m* are integers that may be the same or different, such as a 3 × 3 array of beams, a 4 × 4 array of beams, or a 5 × 5 array of beams.

The condenser lens 504 may be configured to re-direct paths of the beams 521, 522, 523 to be substantially parallel to each other and/or to be incident substantially perpendicularly onto the source conversion unit 506. The condenser lens 504 may be a macro magnetic lens arrangement such as a multiple, e.g. two, lenses set at a non-rotational setting (by which the rotational effect of the different lenses of the lens arrangement cancel or their net rotational effect on the paths of the beams is substantially zero).

The source conversion unit 506 may include a beam-limiting aperture array 531 defining apertures configured to laterally limit each of the beams 521, 522, 523. The beam-limiting aperture array 531 may shape one more of the beams 521, 522, 523 for example to separate the beams into two or more beams down beam of the beam-limiting aperture array 531 for example towards a sample.

The source conversion unit 506 may comprise an array of electron-optical components for operating on each beam or a group of beams of the plurality of beams. The source conversion unit 506 may include an image-forming element array 532 comprising an array of micro-deflectors configured to deflect the beams 521, 522, 523 towards the axis 510. The deflected beams 521, 522, 523 may form virtual images of the source crossover 514 on the sample 208.

The source conversion unit 506 may include an aberration compensator array 534 configured to compensate aberrations in the beams 521, 522, 523. The aberration compensator array 534 may be configured to compensate for field curvature and/or astigmatism for example.

The source conversion unit 506 may include a pre-bending micro-deflector array 533 configured to bend paths of the beams 521, 522, 523 upbeam of the beam-limiting aperture array 531, for example to cause paths of the beams 521, 522, 523 to be incident substantially perpendicularly onto the beam-limiting aperture array 531.

The image-forming element array 532, the aberration compensator array 534, and/or the pre-bending micro-deflector array 533 may comprise multiple layers of sub-beam manipulating devices, some of which may be in the form of arrays, for example: micro-deflectors, micro-lenses, and/or micro-stigmators.

In the example shown, the objective lens 508 comprises a magnetic lens that acts macroscopically on the beams to focus the beams onto the sample 208. In other embodiments, the objective lens 508 may comprise an objective lens array implemented electrostatically, or a combination of magnetic and electrostatic lenses may be used; for example a macro magnetic objective lens with electrostatic elements.

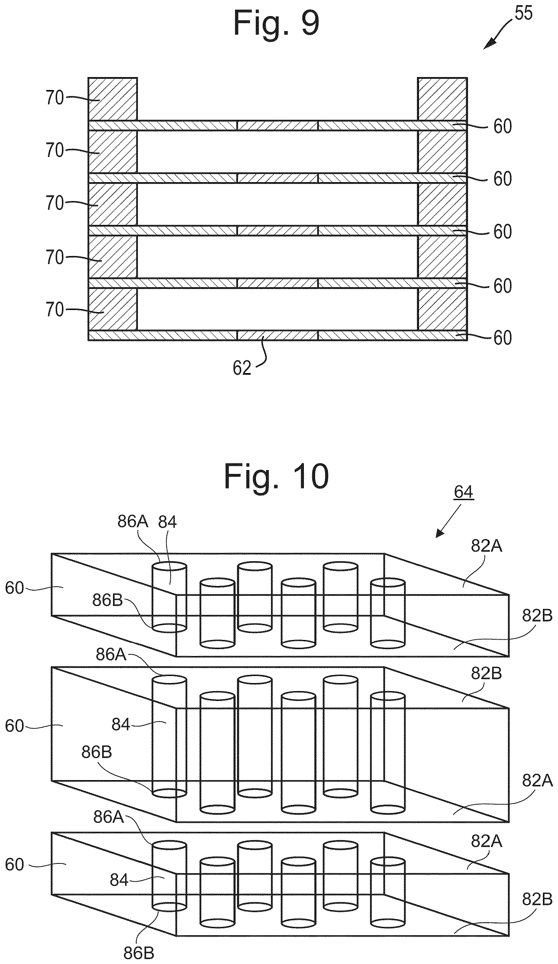

**FIG. 9** depicts an electron-optical module 55. The electron-optical module 55 may comprise an electron-optical stack. The electron-optical stack comprises a plurality of electron-optical plates 60. The electron-optical stack may form part of any of the electron-optical devices 41 disclosed herein, for example as described with reference to **FIG. 3****,** **7** and **8****.** The electron-optical stack may be provided as part of an assessment device for assessing a sample. The electron-optical stack may be, or form part of, an electron-optical lens assembly. The electron-optical lens assembly may comprise an objective lens array or assembly, or a condenser lens array or assembly, or may be an objective lens array or assembly, or a condenser lens array or assembly. Additionally or alternatively, the electron-optical stack may be or form part of, for example as a respective array, a collimator, a corrector such as an individual beam corrector, a detector array, a deflector and/or one or more elements of a Wien filter array. For example in an embodiment shown in and described with reference to **FIG. 3****,** the stack 55 may comprise detector module 402, objective lens array 401, and control lens array 250. In an embodiment shown in and described with reference to **FIG. 8** the stack may comprise at least part of the source conversion module 506. That is the electron-optical module 55 may comprise, or may even be, a source conversion module 506

The electron-optical module 55 is configured to direct charged particles along at least one beam path towards a sample location. In the orientation shown in **FIG. 9****,** the at least one beam path extends vertically from top to bottom through the middle of the electron-optical stack. There may be one beam path corresponding to one charged particle beam. Alternatively, there may be a plurality of beam paths corresponding to a plurality of charged particle beams of a multi-beam.

As shown in **FIG. 9****,** in an embodiment the electron-optical module 55 comprises a plurality of planar elements arranged across the beam path. In an embodiment one or more of the planar elements is an electron-optical plate 60 (which may also be referred to as an electron-optical element). The electron-optical plate 60 is configured to operate on the one or more electron beams. As shown in **FIG. 9****,** in an embodiment all of the planar elements are electron-optical plates 60. Alternatively, one or more of the planar elements may be a planar element other than an electron-optical plate. For example, one or more of the planar elements may be an element that is not required to have a voltage applied to it to perform its function, or the planar element is required to have a voltage applied to it so there is substantially zero potential difference between the element and an adjacent element along the beam path. One example is a planar element that is a beam limiting aperture array comprising apertures dimensioned to shape the charged particle beams. For example, the apertures may allow charged particle beams of a particular shape to pass through, while blocking other charged particles from propagating through the beam limiting aperture array. As a further alternative, a planar element configured to shape the charged particle beams may also have a potential difference with respect to an upbeam and/or downbeam planar element such that the electromagnetic field affects the charged particle beams in addition to the beam shaping function. In an embodiment one or more of the planar elements may be a detector such as a detector array.

As shown in **FIG. 9****,** in an embodiment the electron-optical module 55 comprises one or more spacers 70. The spacers 70 are configured to mechanically support the planar elements. As shown in **FIG. 9****,** in an embodiment a spacer 70 is configured to mechanically separate planar elements such as electron-optical plates 60 from each other. In an embodiment the spacers 70 are configured to electrically isolate planar elements such as electron-optical plates 60 from each other. However, it is not essential for the spacers 70 to provide electrical isolation. For example, it may be that two adjacent electron-optical plates 60 are arranged to be operated at the same voltage (i.e. having no potential difference between them), in which case electrical isolation may not be required. In an embodiment one or more pairs of adjacent planar elements are directly joined to each other, i.e. without an intermediate spacer 70. The spacers 70 are optional features.

In an embodiment, the electron-optical module 55 is configured so that the charged particle beams pass through a beam area 62 of the electron-optical module 55. As shown in **FIG. 9****,** the beam area 62 may be in a central portion of the electron-optical module 55. The beam area 62 is located generally centrally when viewed in a direction parallel to the at least one beam path. The beam area 62 is located centrally when viewed in a direction orthogonal to the plane of the planar elements. It is noted that in an embodiment in one or more of the plates 60 may be a single macro aperture. Such a macro aperture may be positioned to correspond to the beam area of another of the plates 60. Such a stack with a macro aperture may be or comprise a condenser lens array 231 as shown in and described with reference to **FIG. 3** and **FIG. 7****.** In an arrangement, the one or more of the plates 60 may comprise a plurality of apertures (or meso apertures) corresponding to groups of beam paths in the beam area. A stack comprising a one or more plates with meso-apertures may comprise a Wien filter array 95.

In an embodiment the electron-optical module 55 is comprised in an electron-optical device 41, for example an electron-optical device 41 as shown in **FIG. 3****,** **FIG. 7****,** or **FIG. 8****.** In an embodiment the electron-optical module 55 is field replaceable. The electron-optical module 55 may be removed from and/or inserted into the electron-optical device 41, without requiring any substantial dismantling of other parts of the electron-optical device 41. That is the electron-optical module 55 may be removable from and/or insertable into the electron-optical device 41.

As described above, electron-optical elements such as plates 60 may be configured to act as electrodes, for example as part of an objective lens array. Geometric features of the plates 60 allow charged particle beams to pass through the plates 60. Such features are: channels through the plates 60 and apertures defined in surfaces of the plates. An aperture may be defined by a respective channel opening in a surface. A channel (which may be referred to as a through-hole) may connect different apertures in opposing surfaces of a plate. Electric fields adjacent to apertures associated with the channels may apply a lensing effect to the charged particles. In some arrangements, the apertures may be adapted to compensate for aberrations, for example for off-axis aberrations in a multi-beam such as distortion, focus curvature, astigmatism and coma. For example, the apertures of one or more of the electrodes may be shaped, sized and/or positioned to compensate for off-axis aberrations. The apertures may, for example, have a range of different areas (or a range of diameters) to compensate for field curvature, a range of different ellipticities to compensate for astigmatism, and/or a range of different displacements from nominal grid positions to compensate for distortion caused by telecentricity error. See for example EPA 21166214.3 filed on 31 March 2021 which is hereby incorporated by reference so far as off-axis aberration correction.

Performance of electron-optical elements may be highly sensitive to variations in properties of the apertures such as their shapes, sizes and/or positions, particularly where these features are deliberately configured to correct for aberrations.

Features in electron-optical plates 60 may be manufactured using techniques from microelectromechanical system (MEMS) (i.e. using MEMS manufacturing techniques). Errors during manufacture of electron-optical plates 60 can affect electron-optical performance of the plates. Such errors may be unexpected structural features created during processing steps of manufacture. Small perturbations to a nominal shape of an aperture can lead to significant aberrations in a charged particle beam passing through the aperture. The effect of perturbations may be magnified by strongly curved fields in the vicinity of the aperture. Such perturbations may be of up two orders of magnitude larger than the compensations intentionally applied to apertures for example to compensate for off-axis aberrations. However, it is expected that such perturbations may often be smaller than the order of magnitude of the compensations applied to the apertures.

**FIG. 10** depicts an exemplary electron-optical stack 64 configured to manipulate a plurality of charged particle beams. The stack 64 comprises a plurality of electron-optical plates 60. As described above with reference to **FIG. 9****,** the stack 64 may be part of an electron-optical module 55. The stack 64 and/or module 55 may take any of the forms described above with reference to **FIG. 9****.** The plurality of plates 60 may thus be configured to allow at least adjacent plates 60 to be maintained at different electrical potentials, for example to provide a lensing effect. The adjacent plates may thus be electrically isolated from each other. In some embodiments, a spacer 70 is provided between adjacent plates. The spacer 70 may electrically isolate the adjacent plates 60 and/or support the adjacent plates 60.

As shown in **FIG. 10****,** the plurality of plates 60 have major surfaces 82A, 82B on opposite sides of the plates 60. Each plate 60 thus has two major surfaces 82A, 82B. The major surfaces 82A, 82B are the largest surfaces of the plates 60. The major surfaces 82A, 82B are typically planar surfaces and/or have much larger surface areas than other surfaces of the plates 60 (e.g., side surfaces of the plates). In the orientation of the stack 64 shown in **FIG. 10****,** each plate 60 has a major surface on the top of the plate 60 and a major surface on the bottom of the plate 60.

The plates 60 define one or more sets of channels 84 for example between the major surfaces of the plates. Thus apertures in the major surfaces of a plate may define a respective channel through the plate. As depicted, each set of channels 84 is configured to be aligned along a beam path of a respective charged particle beam. In the depicted arrangement the channels of the set of channels and the respect beam paths are substantially orthogonal to the planes of the different plates 60 (although that need not be the case for the beams to be aligned with the different channels). The alignment of the channels 84 in each set allows the charged particle beam to pass through the plates 60 via the channels 84 of the set. In embodiments configured to operate with a single charged particle beam, a corresponding single set of the channels 84 may be provided. In embodiments configured to operate with a plurality of charged particle beams (which may be referred to as a beam grid), the plurality of plates 60 may define a plurality of the sets of channels 84 (or an array of channels or a channel grid) for a corresponding plurality of paths of different charged particle beams (e.g., of a beam grid). Each set of channels 84 corresponds to a respective charged particle beam. As depicted the beam paths of the beam grid are collimated, substantially all the beam paths are orthogonal to the plane of the plate such as one of its major surfaces and the beam path is parallel to the axis of a corresponding channel.

For example, each channel 84 defines apertures 86A, 86B in the two major surfaces 82A, 82B of the plate 60 that defines the channel 84. Thus, in the example of **FIG. 10****,** six apertures are defined along each of the beam paths through the plates 60. Two apertures 82A, 82B are associated with each channel 84. When an electrical potential is applied between adjoining plates, for example at least around facing apertures in the different adjoining plates, a field is generated between the facing apertures. The field may operate on a charged particle in a beam along a beam path for example to lens the beam. In an embodiment, the plurality of plates 60 is configured to operate as an Einzel lens.

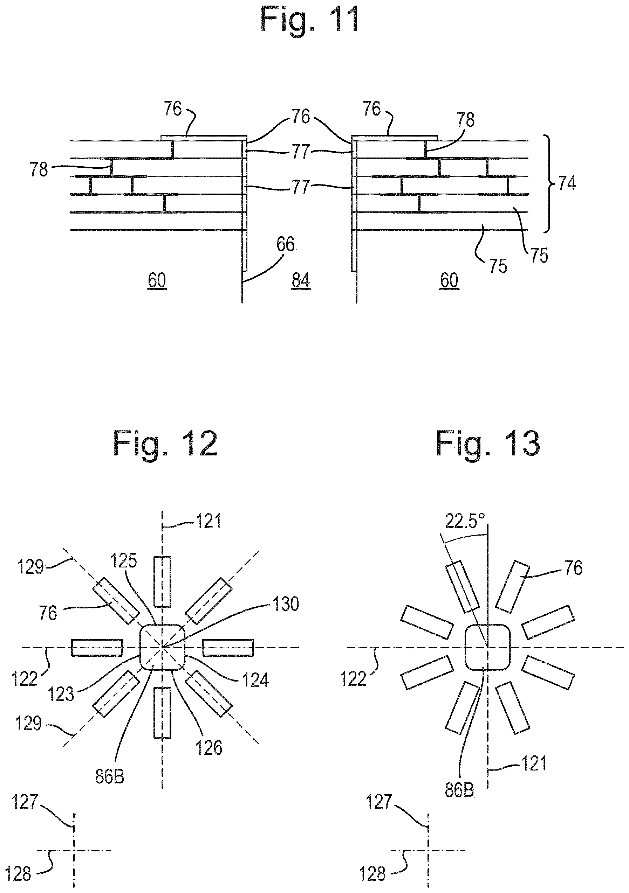

**FIG. 11** is a schematic diagram showing a cross-sectional view of an electron-optical plate 60 in the vicinity of a channel 84 through the plate 60. As shown in **FIG. 11** in an embodiment the plate 60 comprises a CMOS device. The plate 60 may be implemented by integrating a CMOS chip corrector into the plate 60 (which may be a lens plate or a separate element) of an electron-optical lens array. A CMOS chip has architecture comprising a plurality of conductive layers between which are isolating layers. The conductive layers may be connected to each other through the insulating material using silicon vias. It is noted that the CMOS device provides an embodiment of circuitry for connecting and controlling the different electrodes.

In an embodiment multiple electrodes 76 are provided around an aperture of the channel 84. The channel 84 may define a through path through the plate 60. The channel 84 may define a path for an electron-optical beam. Circumferential gaps may be defined in between adjacent electrodes 76. Such a circumferential gap between adjacent electrodes may isolate the adjacent electrodes. The circumferential gaps and electrodes may lack rotational symmetry for example may not have rotational symmetry, yet may have reflective symmetry. The reflective symmetry may be of positions that are segments relative to the geometrical axis of the channel 84. The electrodes 76 are configured to perform correction by any order of multipoles such as two-pole (2 pole), four-pole (4 pole), six-pole or hexapole (6 pole), eight-pole or octupole (8 pole), ten-pole (10 pole), twelve-pole (12 pole), fourteen-pole (14 pole), sixteen-pole (16 pole) or any other higher order of multi-pole. A two pole may have a single order of reflective symmetry. A four pole may have second order reflective symmetry. A hexapole may have three fold reflective symmetry. An octupole may have four fold reflective symmetry. A twelve pole may have six fold reflective symmetry, Such multipole of electrodes may be considered a corrector. The electrodes 76 may be configured to perform an operation on a beam through the path the channel such as a correction. The correction may adjust, e.g. correct, of one or more attributes of one or more aberrations such as off axis aberrations such as astigmatism and position (i.e. inter beam alignment or intra-multibeam array alignment).

In an embodiment, the electrodes 76 are of metal surfaces such as a metal surface layer of a layered structure which may be a device such as a CMOS device which may be referred to as a CMOS chip. The electrodes 76 can be formed in other (i.e. additional) layers of the device. Power and control signals of the device may be connected to the device by through-silicon vias 78 for example from an adjoining conductive structure such as an adjoining substrate. For robustness, desirably a passive silicon substrate with holes (e.g. a shield plate 73) shields the device from high E-fields (not shown in **FIG. 11****).** It is not essential for the device to be a CMOS device. It is not essential for the device to be multi-layered. For example, in an alternative embodiment the device comprises single layer traces on a substrate.

As shown in **FIG. 11** the beam channel 84 is defined by electrodes 76 that surround the channel 84. On a surface of the planar substrate of the plate 60, a circuit 74 such as an electronic control circuit is arranged for connecting and controlling the electrodes 76. In an embodiment the circuit 74 comprises integrated circuitry which is arranged adjacent to, for example around the channel 84 desirably within the layers 75 of the device. In this example the circuit 74 is built up from a plurality of layers 75 with integrated electronic circuitry. The circuit 74 may be on one more layers of the device. The layers 75 are interconnected by vias 78. In an embodiment the plate 60 comprises at least part of the circuit 74. In an embodiment the inner surface of the plate 60 extends from the part of the electrode 76, perpendicular to, the beam paths to the opposing face of the substrate of the plate 60, desirably through the plate 60. The electrode 76 may extend along part of or even the full surface of the channel 84 through the plate 60.

In an embodiment circuitry associated with a detector element within the corrector plate may comprise at least part of the control circuitry of the controller 50 for example the part of the controller associated to the detector element. Components of the controller circuitry in the circuitry layer may include a de-serializer, a digital to analogue converter and an amplifier. In an embodiment at least part of the control circuitry is remote from the corrector plate, desirably remote from the electron-optical device such as external to a vacuum chamber within which the electron-optical device is located.

In an embodiment, at the edge or surface of the channel 84, edge vias 77 are provided. The edge vias 77 are connected in an embodiment to the electrode 76. In an embodiment the edge vias 77 are formed integrally as part of the electrode 76; that is the electrode 76 may comprise edge vias 77. The edge vias 77 provide an extension of the electrode 76 inside the channel 84 or provide the surface of the through-hole through the plate 60. Thus the electrode 76 of a channel 84 is at least partially arranged against an inward facing wall of the channel 84. The electrode is at least partly provided at a surface into the substrate and on the substrate. The edge vias 77 may be manufactured at the same time and using the same process used for the manufacture of the integrated electronic control circuit 74, for example using CMOS architecture and using processes for processing CMOS structures.

In an embodiment, each of the channels 84 is provided with a plurality of electrodes 76 arranged around the beam channel 84 on the substrate of the plate 60. At a distance above the substrate of the plate 60, another plate (not shown in **FIG. 11****)** may be arranged. The other plate may also comprise an array of channels 84, which are aligned with the channels 84 of the plate 60. In an embodiment such another plate and the plate 60 may correspond to the arrangement of two of the plates 60 shown in and described with reference to **FIG. 10****.**

As shown in **FIG. 11** in an embodiment the electrodes 76 extend along the wall (or surface) of the beam channel 84 (or through passage through plate 60) further than the layers 75 optionally of the circuit 74. Alternatively, the electrodes 76 may extend along the wall of the beam channel 84 substantially the same distance as (or a shorter distance than) the layers 75 of the circuit 74. In an arrangement the electrodes may extend to a position intermediate the furthest extent of the layers 75 and the aperture of the channel 84 at an opposing end of the channel 84. In an arrangement the electrodes may extend all the way through the channel 84 i.e. to the opposing end of the channel 84. As shown in **FIG. 11** in an embodiment an uncovered part 66 of the wall defining the beam channel 84 (or surface of the beam channel 84) is uncovered; that is the beam channel 84 does not provide a surface of the electrodes 76 for example is not covered by the electrodes 76. In an embodiment the uncovered part 66 may be recessed relative to the surface of the electrode 76 on the inner surface of the substrate. That is the inner surface through the substrate may be stepped to a larger diameter where the electrode 76 terminates for example within the plate 60. Such a stepped surface may desirably reduce the risk of unwanted discharge.

In an embodiment the electrodes 76 are formed as a layer such as a coating at the surface of the substrate. In an alternative embodiment the electrodes 76 are made of doped portions of the substrate of the plate 60; the doped portions may be formed as a layer to provide the electrodes. For example the electrodes 76 may be formed of doped silicon.

In an embodiment the controller 50 is configured to control the electrodes 76 through a serial bus. In an embodiment the device is programmed through the serial bus. This can help to reduce the number of electrical connections required in order to control the electrodes 76. An embodiment of the invention is expected to make it easier and/or cheaper to manufacture an electron-optical device with a strong aberration corrector.

In an embodiment the plate 60 comprises a digital to analogue converter. In an embodiment the digital to analogue converter is configured to convert control signals from the controller 50 into electrode signals to the electrodes 76.

In an embodiment the electron-optical lens assembly comprises a plurality of plates 60 each having an array of apertures for passage of beam paths and an array of lenses configured to control lensing at respective beam channels 84. In an embodiment the plate 60 is a lens plate configured to perform a lensing function at the apertures 86A, 86B. The lenses may be connected to a common controllable electrical potential. In a such an arrangement the plate may have circuitry connected to an electrode assigned to each aperture. In another arrangement, at least the surface of the plate may be of electrically conductive material such that the surface of the plate functions as a common electrode, such as for all the apertures defined in the surface of the plate.

In an embodiment an electron-optical plate 60 comprises a substrate. The substrate may form the main body of the electron-optical plate 60. In an embodiment the substrate 60 has a crystalline structure. The substrate may comprise a material having a crystalline structure. For example, in an embodiment the substrate comprises silicon. The silicon may have a crystalline structure. Other materials having a crystalline structure may be used additionally or alternatively to silicon.

In an embodiment the substrate has a regular crystal structure. For example, silicon has a diamond cubic structure. In an embodiment the crystalline structure has crystalline lines of symmetry. In an embodiment the substrate is grown from a crystal having a regular crystal structure. In an embodiment the substrate is provided by cutting a crystal. For example, the crystal may be cut into a plurality of substrates. The surface of the substrate may be aligned in a crystal orientation direction.

In an embodiment a plane of the substrate is parallel to a plane of the crystalline structure. The plane of the crystalline structure may be selected from a group consisting of a (100) plane, a (110) plane and a (111) plane. For example, in an embodiment a plane of the substrate of the electron-optical plate 60 is parallel to a (100) plane of the crystalline structure.

A (100) plane comprises a (010) plane and a (001) plane. A (100) plane is equivalent to a (010) plane and a (001) plane. A substrate with a plane parallel to a (100) plane may have two crystalline lines of symmetry. It may be considered that a substrate with a plane parallel to a (100) plane has two lines of symmetry if the atoms and bonds to other atoms are taken into account. Meanwhile it may also be considered that a substrate with a plane parallel to a (100) plane has four lines of symmetry if only the atoms (and not also bonds to other atoms) are taken into account. Unless stated otherwise, the crystalline lines of symmetry are stated based on taking into account the atoms and bonds to other atoms. The two crystalline lines of symmetry may be perpendicular to each other. As shown in **FIG. 12****,** in an embodiment the aperture 86B may tend to have a shape that is slightly square. The slightly square shape may be partly due to the crystalline lines of symmetry of the (100) plane of the crystalline structure, for example due to the manufacturing process as is later herein described.

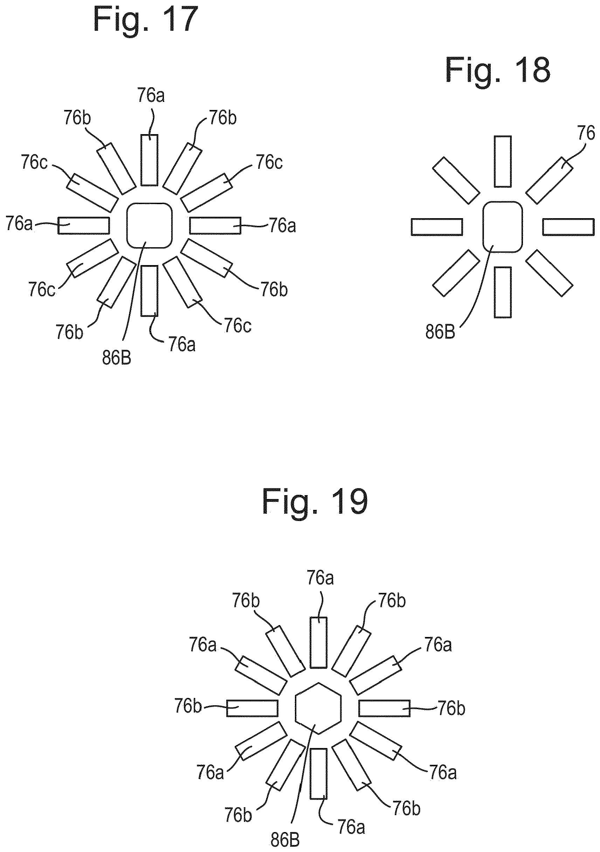

In an embodiment a plane of the substrate of the electron-optical plate 60 is parallel to a (110) plane of the crystalline structure. The (110) crystalline structure comprises a (101) plane and a (011) plane. The (110) plane is equivalent to a (101) plane and a (011) plane. There may be two crystalline lines of symmetry. There two crystalline lines of symmetry may be perpendicular to each other. As shown in **FIG. 18****,** in an embodiment the aperture 86B may be slightly rectangular shaped. The rectangular shape may be at least partly due to the crystalline structure of the (110) plane of the crystalline structure.

In an embodiment a plane of the substrate of the electron-optical plate 60 is parallel to a (111) plane of the crystalline structure. The crystalline structure may have at least three crystalline lines of symmetry. The crystalline lines of symmetry may have 60° angles between them. As shown in **FIG. 19****,** in an embodiment the aperture 86B may be slightly hexagonal shaped. The hexagonal shape may be at least partly due to the crystalline structure of the (111) plane of the crystalline structure.

As shown in **FIG. 10****,** in an embodiment the electron-optical plate 60 comprises a plurality of channels 84. The channels 84 are configured for passage of a plurality of beam paths of a beam grid through the substrate of the electron-optical plate 60. The channel 84 is a through passage. The channel 84 extends through the substrate. The channel 84 opens out to the major surfaces of the substrate at the apertures 86A, 86B.

**FIG. 12** schematically shows an arrangement of electrodes 76 for a multipole. In an embodiment the electron-optical plate 60 comprises a plurality of multipoles associated with respective channels 84. As shown in **FIG. 12****,** in an embodiment each multipole comprises a plurality of electrodes 76 for the associated channel 84. In an embodiment the electrodes 76 are arranged around the aperture 86B when viewed in a direction along the beam path.

In an embodiment the electrodes 76 are arranged such that geometrical lines of symmetry of the multipole are parallel to respective crystalline lines of symmetry of the crystalline structure. For example, **FIG. 12** shows an aperture 86B that is slightly square shaped. The slight square shape corresponds to the crystalline lines of symmetry 127, 128 of the crystalline structure. The crystalline lines of symmetry 127, 128 are parallel to the geometrical lines of symmetry of the aperture 86B. In the example shown in **FIG. 12****,** one crystalline line of symmetry 127 may extend parallel to the left side 123 and the right side 124 of the square shape. Another crystalline line of symmetry 128 may extend parallel to the top side 125 and bottom side 126 of the square shape.

As shown in **FIG. 12****,** the electrodes 76 are arranged to have geometrical lines of symmetry 121, 122. The geometrical lines of symmetry 121, 122 of the multipole are parallel to the crystalline lines of symmetry 127, 128 of the crystalline structure. As shown in **FIG. 12****,** the electrodes 76 are arranged to have a geometrical line of symmetry 121 that extends parallel to the left side 123 and the right side 124 of the square shape of the aperture 86B (i.e. extending downwards through the middle of the square shape shown in **FIG. 12****).** The electrodes 76 may be arranged such that the multipole has another geometrical line of symmetry 122 that extends parallel to the top side 125 and the bottom side 126 of the square shape of the aperture 86B (i.e. horizontally through the middle of the square shape shown in **FIG. 12****).**

In an embodiment the multipole comprises further geometrical lines of symmetry. For example, the arrangement shown in **FIG. 12** has further geometrical lines of symmetry 129 that extend diagonally through the middle of the aperture 86B.

In an embodiment the geometrical lines of symmetry 121, 122 of the multipole are with respect to the respective channel 84. In an embodiment the electrodes 76 are arranged with respect to the respective channel 84. In an embodiment the electrodes 76 are arranged around an axis 130 of the channel 84 through the substrate and/or a respective beam of the plurality of electron beams through the substrate.

In an embodiment an individual multipole is positioned relative to the respective channel 84. For example, the electrodes 76 may be positioned around the channel 84. In an embodiment the electrodes 76 are positioned around a beam path of a respective electron beam of the plurality of electron beams through the respective channel 84.

By aligning the electrodes 76 of the multipole with the crystal orientation of the substrate of the electron-optical plate 60, aberrations due to the non-circular shape of the aperture 86B may be better corrected/compensated for. That is the impact or effect of the aberrations due to the rotationally unsymmetric shape of the aperture 86B may be reduced or ameliorated if not prevented (i.e. corrected). This can improve the resolution of an electron-optical device comprising the electron-optical plate 60.

An embodiment of the invention is expected to achieve improved resolution of manipulation of electron beams by an electron-optical plate 60. An embodiment of the invention is expected to improve correction of electron-optical aberrations such as an octupole aberration.

An embodiment of the invention is expected to achieve a multipole orientation that is more optimized for compensating aberration effects caused by etching, such as anisotropic etching. Anisotropic etching can cause the hole on one side of a plate to be a different same shape from the hole at the other side. For example, there may be a difference in a diameter and/or shape. Anisotropic etching may result from there being a dependency of etch speed along crystal (symmetry) lines. An embodiment of the invention is expected to achieve improved correction of an octupole aberration without requiring a multipole having at least sixteen (16) electrodes 76. A multipole having at least sixteen (16) electrodes 76 is harder to manufacture compared to a multipole having a smaller number of electrodes 76. An embodiment of the invention is expected to make it easier to manufacture a plate 60 that can correct an octupole aberration.

An embodiment of the invention is expect to achieve increased tolerance for the etching process of channels 84 through an electron-optical plate 60. For example, there may be increased tolerance for how round apertures 86A, 86B are, the diameter of apertures 86A, 86B, and/or the straightness of walls of the channels 84.

An embodiment of the invention is expected to increase design freedom for other components of the electron-optical device. For example, the orientation of deflectors may be more freely chosen without reducing electron-optical performance.

Features in electron-optical plates 60 may be manufactured using techniques from microelectromechanical system (MEMS) (i.e. using MEMS manufacturing techniques). These manufacturing techniques create small structures with high precision but are subject to imperfections, for example with respect to the intended design. Some such imperfections may be induced by the processing steps used. MEMS manufacturing techniques create features having dimensions in the range of from about 1µm to about 500µm.

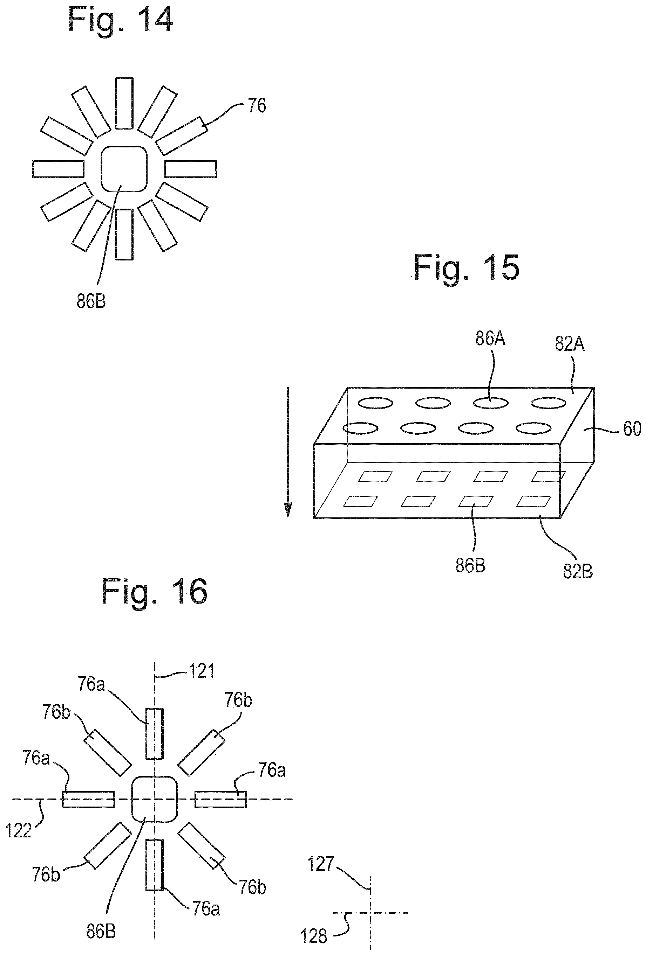

As shown in **FIG. 10** and **FIG. 15****,** in an embodiment the substrate comprises opposing major surfaces 82A, 82B. The opposing major surfaces 82A, 82B are connected by the channels 84. In an embodiment the channels 84 terminate at apertures 86A, 86B in the major surfaces 82A, 82B. In an embodiment the substrate is planar. In an embodiment the apertures 86A at one of the major surfaces 82A are shaped differently from the apertures 86B at the other of the major surfaces 82B. In an embodiment an aperture 86A, 86B defined by a respective channel 84 in the different major surfaces 82A, 82B is different.

**FIG. 15** schematically shows an electron-optical plate 60. The apertures 86A at one major surface 82A of the plate 60 may be shaped differently from the apertures 86B at the other major surface 82B of the plate 60. This difference may be an unintended imperfection for example derived from manufacturing such as processing as used in manufacturing MEMS type components.

The inventors have noticed that techniques for forming channels through plates can lead to subtle differences in the shapes of apertures defined at ends of the channels (or the apertures in the surfaces of the plate though which the channel extends; or the apertures defined in the opposite surfaces of the plate by the intersection of the channel and the opposite surfaces). Such differences may be exaggerated in **FIG. 15** for clarity of illustration. Such differences may particularly be formed where the channels have relatively high aspect ratios (i.e., channels that are relatively long compared with their diameter; or the dimensions of the distance between the apertures on opposite surfaces relative to the cross-sectional dimensions of the apertures i.e. the cross-section dimensional of the channel at any point between the apertures). Such effects may have more significant consequences the further an electrode, such as electrode 76 extends through the channel for example from aperture 86A towards the other aperture 86B for example extending between the two apertures 86A 86B.

For example, such channels may be formed in a plate 60 by an etch process performed from one side of the plate 60. That is the apertures are formed by etching the channel through the plate for example from one surface of the plate to the opposite surface. In such an embodiment, the shape of the channel can be controlled with higher accuracy at the start of the channel (i.e., where the etching of the channel starts for example at a starting aperture) than at the end of the channel (i.e., where the etching of the channel is completed for example at an ending aperture). That is the shape of the cross-section of the channel may change (e.g., in shape and/or size and/or orientation with respect to a frame of reference of the surface in which the starting aperture is formed) with increasing distance from the starting aperture. This results in channels having differently formed apertures (for example different in shape, size and/or orientation) at each end. That is the two apertures (such as the starting aperture and the ending aperture) may be of different forms (e.g. different in shape, size and/or orientation). The inventors have observed that this can lead to undesirable aberrations in charged particle beams if no or insufficient counter measures are taken. An embodiment of the invention is expected to allow for compensation of such undesirable aberrations.

Such differences in apertures in facing surfaces such as having a plate such as shown in and described with reference to **FIG. 15** present in the arrangement shown in and described with reference to **FIG. 10** may result in facing surfaces having apertures with a mismatch in shape facing each other. The electric field between surfaces around such facing mismatched apertures may generate an aberration in the beam through the facing apertures; that is the electric field is perturbed by the mismatch in shape. Such perturbations may be observed as aberrations.

A difference between the nominal shape and the perturbed shape may be relatively small. For example, relative to an axis perpendicular to a plane of the plates 60 and passing through a geometrical center of an aperture, an average azimuthal variation in a radius of an aperture having the perturbed shape may represent less than 10%, optionally less than 5%, optionally less than 1%, of an average or absolute radius of the corresponding nominal shape. For example, in the case where the nominal shape is a perfect circle, the perturbed shape may have an average azimuthal variation in radius of less than 10%, optionally less than 5%, optionally less than 1%. In an embodiment, within each set of channels 84 apertures 86A having the nominal shape (or simply the nominally shaped apertures) are more similar in shape to each other than to any of the apertures 86B having the perturbed shape (or the perturbed shaped aperture). Additionally or alternatively, in an embodiment, within each set of channels 84 apertures 86B having the perturbed shape (or the perturbed shaped apertures) are more similar in shape to each other than to any of the apertures 86A having the nominal shape (or the nominally shaped apertures). For example the nominally shaped apertures may have substantially the same shape; the perturbed shaped apertures may have substantially the same shape; the nominally shaped apertures and the perturbed shaped apertures may have substantially different shapes.

In some embodiments, as mentioned above, the channels 84 defined in the plates 60 are obtainable in each plate by an etching process. The etching process may result in the different shapes of aperture 86A, 86B in the major surfaces 82A, 82B of the plate 60. The channels are etched such that the shapes of the apertures on the major surfaces on opposite sides of the plates are different. The channels 84 may be referred to as etched channels. Imperfections in the etching process may lead to the different shapes of aperture. It may be possible to refine a recipe for the etching process to reduce or eliminate the differences in shape but this would be time-consuming and/or expensive to implement. An impact of imperfections in the etching process may be larger in respect of forming the nominal shape in comparison with forming the perturbed shape. The aperture at an end of a channel where etching started may have the nominal shape and the aperture at the other end of the channel (where the etching ended) may have the perturbed shape. It may be more difficult comparatively to accurately etch an ending aperture than a starting aperture for example by etching a channel through a thick substrate (which may be referred to as a 'deep channel' or a deep etch). That is, in etching the ending aperture by such a deep etch, it may be challenging to retain the cross-sectional shape of the starting aperture (for example as the nominal shape) as the cross-sectional shape of the channel especially for the whole depth of the etch and/or channel; the ending aperture consequently may have the perturbed shape.

In an embodiment, the nominal shape is the same for two or more, optionally for all, of the channels 84, at least within a set of the channels. The nominal shape may be a circle or an ellipse for example. The nominal shape is not particularly limited and will be selected according to electron-optical requirements of the stack 64. As mentioned above, these requirements may include correction of aberrations. The correction of aberrations may be performed using different shapes of aperture for different charged particle beams, desirably when a field is present between facing surfaces. In an embodiment, such a correction may be in the range of 0.1% to 1% of the dimension of the aperture. The nominal shape may thus be different for two or more of the sets of channels 84. Alternatively or additionally, the nominal shape may be the same for two or more of the sets of channels 84.

The inventors have found that the perturbed shape comprises a perturbation component that depends on the crystallographic symmetry of the plate 60. The perturbation component may be a dominant component of the perturbation. In some embodiments, the perturbed shape comprises a perturbation component with rotational symmetry of order two or more. In some embodiments, the perturbed shape comprises a perturbation component with rotational symmetry of order less than 10. In an embodiment, the perturbation component has rotational symmetry of order 4 or a multiple of 4. This has been found to be the case where the plates 60 consist of, consist essentially of, or comprise, silicon. In an embodiment, the perturbation component has rotational symmetry of order 6 or a multiple of 6. This may occur for different crystal orientations within the plate 60. For example, where silicon in the plate 60 is oriented such that the major surfaces of the plate 60 are perpendicular to the [111] crystal direction, the crystallographic structure parallel to the plane of the plate 60 would have hexagonal symmetry and contribute a perturbation component having rotational symmetry of order 6, as shown in **FIG. 19****.** More generally, in an embodiment, the perturbation component has rotational symmetry determined by the crystalline structure of the material of the plate, for example the crystal orientation of the material of the plate. Such perturbation component therefore may depend on the crystal orientation within the plate, for example with respect to the major surfaces of the plate 60 and the order of symmetry of the crystalline structure of the material.

As described elsewhere, in an embodiment the electron-optical device is for projecting electron beams along beam paths to the sample location. However, it is inessential (e.g. not essential) for there to be a plurality of electron beams projected along a plurality of beam paths. In an alternative embodiment, the electron-optical devices for projecting a single electron beam along a single beam path to the sample location. The electron-optical plate 60 may have a single channel 84 configured for the beam path of electrons through the substrate of the electron-optical plate 60. In an arrangement the plate may take the form of a cylinder through which the single channel is defined, for example along the axis of the cylinder, for example as an axis common to the channel 84.

As shown in **FIG. 10****,** **FIG. 11** and **FIG. 15****,** in an embodiment each channel 84 has a diameter no greater than a thickness of the substrate (or plate) through which the channel 84 extends. The channel 84 may be referred to as a high aspect ratio channel 84. The channel 84 may be relatively long and narrow.

Thicker substrates have longer channels 84 extending through them. Longer channels 84 may be expected to have more pronounced non-circular shapes of the aperture 86B. For example, longer channels 84 may be expected to have apertures 86B that are more square. Aberrations associated with the non-circular shape of the aperture 86B and/or the non-circular cross-section of the channel 84 may be expected to be more pronounced for longer channels 84. An embodiment of the invention is expected to be particularly advantageous for deep substrates.

It is not essential for the channels 84 to have a diameter no greater than a thickness of the substrate; that is a dimension of the diameter smaller than or as large as a dimension of the thickness of the substrate. In an alternative embodiment, each channel 84 has a diameter greater than a thickness of the substrate through which the channel 84 extends; that is the dimension of the diameter larger than the dimension of the thickness of the substrate. Even thin substrates may be expected to have associated fourth order aberrations. An embodiment of the invention is expected to improve compensation/correction for such aberrations, for example reduction if not complete correction of such aberrations.

As shown in **FIG. 11****,** in an embodiment the electrodes 76 are positioned in the channel 84 to provide at least a portion of a surface of the channel 84 for example substantially the entire surface of the channel 84. As shown in **FIG. 11****,** in an embodiment the electrodes 76 extend in a direction through the substrate of the electron-optical plate 60.

As shown in **FIG. 11****,** in an embodiment the electrodes 76 extend to define at least in part a channel wall for example a surface such as of the channel wall. In an embodiment the channel wall defines the channel 84 in a thickness direction of the substrate which may be in the same direction of a path of a charged particle beam. In an embodiment each channel 84 has a diameter as large as or smaller than (or otherwise no greater than) an extent by which the electrodes 76 extend along a surface of the channel in the thickness direction, for example the electrodes 76 extend along the channel wall in the thickness direction of the substrate. For example, in shown in **FIG. 11****,** in an embodiment the electrodes 76 extend only partly along the channel wall in the thickness direction of the substrate. There remains an uncovered part 66 of the wall defining the beam channel 86; that is the uncovered part 66 is not covered by the electrodes 76. The length of the covered part of the wall (i.e. covered by the electrodes 76 such as the edge vias 77) is longer in a direction through the substrate than the diameter of the channel 84.

As shown in **FIG. 10** and **FIG. 15****,** in an embodiment the channels 84 and multipoles are arranged in an array. In an embodiment the channels 84 and multipoles are arranged in a grid, for example the array may be referred to as a grid. For example, the array may be a two dimensional array, such as an array of channels. For example, the grid may have at least two axes; that is the channels may be arranged in a grid having two or more axes. Reference to a grid beam corresponds to the relative positions of the plurality of beams, such as a beam grid.

**FIG. 10** and **FIG. 15** schematically show only part of the array of channels 84. In the arrangement shown in **FIG. 10** and **FIG. 15****,** the channels 84 and multipoles are arranged in a grid that has two axes. The axes are perpendicular to each other. The grid may be a square grid or a rectangular grid. In an alternative embodiment, the grid may have at least three axes. For example, the grid may be a hexagonal grid.

In an embodiment the grid comprises at least three columns. In an embodiment the grid comprises at least five columns for example seven, eleven or more columns. In an embodiment the grid comprises at least three rows. In an embodiment the grid comprises at least five rows for example seven, eleven or more rows. For example, in an embodiment the grid is a 3x3 grid or a 5x5 grid or a 7x7 grid or a 11x11 grid or a 100x100 grid or an NxN grid, where N is any reasonable natural number. The grid may have an equal number of columns and rows. Alternatively, the number of columns may be different from the number of rows. The grid may have a hexagonal arrangement, with a further, third axis. Such a hexagonal grid may have the same features as described for a rectangular grid with two axes. Such a grid may have the same number of lines as the rows and/or columns, such 11x11x11. Such a hexagonal grid may have a hexagonal outline.

In an embodiment the columns extend in a direction corresponding to one of the axes of the grid. In an embodiment the rows extend in a direction corresponding to one of the axes of the grid. When the grid is a hexagonal grid, the positions of the channels 84 may be offset relative to the channels 84 of an adjacent row, for example when considering the positions of the channels along rectangular axes. Alternatively when considering the position of the channels in a hexagonal grid with the axes, the rows, channels and lines of channels extend in a direction corresponding to the hexagonal grid.

In an embodiment the arrangement (e.g. array or grid) of multipoles may have a central axis. The central axis may correspond to the central axis of the electron-optical device 41. In an embodiment one of the channels 84 is located on the central axis. For example, when the multipoles are arranged in a 3x3 grid, then a mid-positioned channel, for example a centrally positioned channel 84 towards the center of the grid, may be located coincident with the central axis. Such a mid-positioned channel may be positioned within a range of distance from the center of the beam grid; such a range may be derived from manufacturing tolerances when making the beam grid. In an embodiment the centre of the beam grid corresponds to the position of the central axis.

For each channel 84, an imaginary straight line (or straight line) connects a centre of the channel 84 and a centre of the grid (i.e. the central axis). The straight line is perpendicular to the central axis. In an embodiment for at least one of the channels 84, and optionally for all of the channels 84, the straight line is parallel to (e.g. coincides with) a geometrical line of symmetry of the multipole.

In an embodiment the imaginary straight line (or straight line) bisects electrodes 76 of the multipole associated with the channel 84. Alternatively, the straight line may bisect a gap between adjacent electrodes 76 of the multipole corresponding to the channel 84. In an embodiment electrodes 76 of different multipoles may be grouped to share a common driver. The driver may be configured to drive the electrode 76 of the multipoles, for example by applying electric potentials to the electrodes 76. The potentials are applied to the facing surfaces of electron-optical plates; thus a field is generated between facing plates, for example between the facing surfaces of the of the facing plates. By providing that the straight line bisects the electrodes or the gap, the multipole is oriented so as to optimize ease of driving control.

In an embodiment, for at least one of the channels 84, and optionally all of the channels 84, the imaginary straight line (or straight line) is parallel to (e.g. coincides with) a crystalline line of symmetry of the crystal structure of the substrate.

In an embodiment, for at least one of the channels 84, an angle between a crystalline line of symmetry and the straight line is greater than (Z/N)180° and less than ((Z+1)/N)180°. Such an angle may be referred to as a relative angle. Z is a zero or a positive natural number. N is the number of electrodes 76 of the multipole associated with the channel 84. For example, when there are eight electrodes 76 (e.g. as shown in **FIG. 12****),** then N is 8, the relative angle is 22.5 °, i.e. 180°/N = 22.5°. In the arrangement shown in **FIG. 12****,** the crystalline lines of symmetry extend 127, 128 in a longitudinal direction in the plane of the surface as represented by the plane of **FIG. 12** (i.e. the up/down direction) and in a lateral (i.e. the left/right direction) in the plane of the same surface. In an embodiment the straight line (connecting the centre of the channel 84 and the centre of the grid) makes an angle with both longitudinal and lateral directions (e.g. the up/down direction and the left/right direction) that is the product of a number intermediate a whole number and the relative angle; that is not the product of a whole number and 22.5° (i.e. is not 22.5°, 45°, 67.5°, 90°, 112.5°, 135°, 157.5° or 180°). The channel 84 is located in a position where the electrodes 76 of its associated multipole would not be aligned with the crystalline structure if the electrodes 76 were oriented so as to optimise ease of driving control (e.g. if the electrodes 76 were oriented so that the straight line bisects the electrodes or the gap between electrodes). The multipoles are oriented so as to improve correction of aberration, such as to reduce if not correct for the aberration.

As shown in **FIGs. 12-14** and **FIGs. 16-19****,** in an embodiment each multipole comprises at least eight electrodes 76,desirably an even number of electrodes, more desirably a number of electrodes that is a factor of four. For example, as shown in **FIG. 12****,** in an embodiment each multipole comprises eight electrodes 76.

**FIG. 13** schematically depicts an alternative arrangement of a multipole. As can be seen from a comparison between **FIG. 12** and **FIG. 13****,** the electrodes 76 of the multipole shown in **FIG. 13** are effectively rotated by the relative angle relative to the positions of the electrodes 76 shown in **FIG. 12****.** The relative angle may be 22.5° compared to the positions of the electrodes 76 shown in and described with reference to **FIG. 12****.** In the arrangement shown in **FIG. 13****,** the electrodes 76 are arranged such that geometrical lines of symmetry of the multipole are parallel to respective crystalline lines of symmetry of the crystalline structure. The crystalline lines of symmetry extend in the longitudinal direction (i.e. the up/down direction) and the lateral direction (i.e. the left/right direction) of the drawing. Geometrical lines of symmetry 121, 122 of the multipole extend in the longitudinal direction and in the lateral direction (in addition to in other directions).

A multipole having eight electrodes 76 is expected to achieve compensation/correction for an attribute of second order aberrations. By orienting the geometrical lines of symmetry with respect to the crystalline lines of symmetry, an embodiment is expected to achieve compensation/correction for fourth order aberrations.

**FIG. 14** is a schematic view of an arrangement of electrodes 76 of another embodiment of a multipole. As shown in **FIG. 14****,** in an embodiment each multipole has 12 electrodes. In an embodiment the multipole is configured to compensate/correct for an attribute of third order aberrations. In an alternative arrangement, the electrodes 76 shown in **FIG. 14** may be rotated around the aperture 86B by a relative angle relative to the positions of the electrodes 76 shown in **FIG. 14****.** Such a relative angle may be 15° compared to the positions of the electrodes 76 without application of the relative angle. (For example this may be similar to how the electrodes 76 shown in **FIG. 13** may be considered to be rotated compared to the electrodes 76 shown in **FIG. 12****).**

It is not essential for the number of electrodes 76 to be eight or 12. For example, in an embodiment one or more of the multipoles has 10 electrodes, or 14 electrodes, for example. It is expected to be easier to appropriately control the electric potentials applied to the electrode 76 in order to compensate for attributes of aberrations when the number of electrodes 76 is eight or 12 (compared to the number of electrodes being ten or 14, for example). The potentials are applied to facing plates so as to generate a field between the facing plates, for example at mismatching facing apertures.

In an embodiment the crystalline structure of the substrate has a rotational symmetry of order of four (4), two (2) or six (6). For example, when the plane of the substrate is parallel to the (100) plane of the crystalline structure, then the crystalline structure may have a four-fold rotational symmetry, i.e. a rotational symmetry of order 4. When the plane of the substrate is parallel to the (110) plane of the crystalline structure, then the crystalline structure may have a two-fold rotational symmetry, i.e. a rotational symmetry of order 2. When the plane of the substrate is parallel to the (111) plane of the crystalline structure, then the crystalline structure of the substrate may have a six-fold rotational symmetry, i.e. a rotational symmetry of order 6.

In an embodiment the controller 50 is configured to control an electrical supply to apply electrical potentials to the electrodes 76. **FIG. 16** is another view of the arrangement of electrodes 76 of the multipole shown in **FIG. 12****.** In an embodiment the controller 50 is configured to control the electric potentials applied to the electrodes 76 so as to compensate for an attribute of aberration. In an embodiment the aberration may be an electron-optical aberration in a beam grid comprising the plurality of beams. In an embodiment the aberration is an electron-optical aberration of a respective beam of the plurality of beams.

The attribute of the aberration may be a type of aberration. The attribute of aberration may be the size of the aberration. The attribute of the aberration may be the proportion of the aberration. Even after correction/compensation, there may remain some aberration.

In an embodiment the electron-optical aberration is associated with another plate 60 of a stack 64 comprising the electron-optical plate 60. The other plate may be upbeam or downbeam of the electron-optical plate 60. The other plate may be adjoining the electron-optical plate 60. The other plate and the electron-optical plate 60 may be in a stack of plates, i.e. sequentially adjoining plates, for example with additional plates interleaving the other plate and the electron-optical plate 60. The other plate may be from a different component comprising a plurality of plates or from an electron-optical plate comprising the electron-optical plate 60. In these different arrangements the other plate and the electron-optical plate operate on the same beams, for example on the same grid of beams. In an embodiment the electrodes of a respective channel in the electron-optical plate 60 are configured to be controlled to compensate, e.g. correct or pre-compensate, the electron-optical aberration of the respective beam. The electron-optical plate 60 may be used to correct for aberrations caused by one or more other components of the electron-optical device 41.

In an embodiment the controller 50 is configured to control the electrical potentials applied to the electrodes 76. The potentials are applied to facing plates so as to generate a field between the facing surfaces, for example at mismatching facing apertures. The potentials may be based on basic potentials and compensation potentials for compensation of an attribute of an aberration of a respective charged particle beam. For example, the compensation potentials may be for correcting or pre-compensating an attribute of the aberration. In an embodiment the compensation potentials of a plurality of the electrodes are equal. For example, in an embodiment the compensation potentials of a plurality of the electrodes 76 of an individual multipole of the grid are equal. For example, in the arrangement shown in **FIG. 16****,** in an embodiment the compensation potentials for electrodes 76a may be equal. The compensation potentials applied to the other electrodes 76b may be equal. The compensation potential applied to the electrode 76a may be different from the compensation potential applied to the other electrode 76b. The potentials applied to the different electrodes 76a to 76c may comprise an operating potential and the compensating potential. The respective operating potentials applied to the different electrodes 76a to 76c may apply an operation to a beam with a path through the aperture 86B of the multiple such as a deflection, beam focus, a focus of beam within the beam grid.

In an embodiment the compensation potentials of a plurality of the electrodes 76 of the plurality of multipoles of the grid are equal.

In an embodiment the electrodes 76a to which equal compensation potentials are applied form a formation that has an electrode rotational symmetry of order n. The rotational symmetry may be about an axis of the respective channel 84. For example, in the arrangement shown in **FIG. 16****,** the electrodes 76a have an electrode rotational symmetry of order 4. In an embodiment the crystalline structure of the substrate has a material rotational symmetry of order n. The material rotational symmetry may be with respect to an axis in a direction orthogonal to the plane of the substrate. The order of the material rotational symmetry may be equal to the order of the electrode rotational symmetry.

In an embodiment the geometrical lines of symmetry 121, 122 of the multipole correspond to the electrode rotational symmetry. In an embodiment the crystalline structure of the substrate has crystalline lines of symmetry 127, 128 corresponding to the material rotational symmetry. The electrodes 76 may be controlled so that electrodes positioned similarly with respect to the symmetry may be controlled in a similar way. An embodiment of invention is expected to facilitate control of the multipoles.

**FIG. 17** schematically shows a multipole that has twelve (12) electrodes 76, for example with six-fold reflective symmetry. Three groups of electrodes are provided according to how they are controlled. In an embodiment equal compensation potentials are applied to the electrodes 76a. Similarly, equal compensation potentials may be applied to the electrodes 76b. Similarly, equal compensation potentials may be applied to the electrodes 76c. The electrodes 76 are grouped according to their position with respect to the symmetry of the multipole. The rotational displacement between adjoining electrodes that are members of different groups may be similar for example around 30 degrees. Within each group, the electrodes may be applied with the same compensation potential. However, different compensation potentials may be applied to different groups for example as described with reference to the disclosure shown in and described with reference to **FIG. 16****.**

As shown in **FIG. 9****,** in an embodiment a stack 64 (e.g. of a module 55) may comprise at least one other plate 60 stacked relative to the electron-optical plate 60. In an embodiment at least one spacer 70 for supporting and/or electrically isolating the electron-optical plate may be stacked relative to the electron-optical plate 60. In an embodiment the other plate has defined therein a plurality of channels comprising apertures with cross-sections which vary in shape along the respective channels. In an embodiment the electron-optical plate 60 is configured to correct an attribute of aberration generated in the plurality of channels of the other plate.

In an embodiment the electron-optical plate 60 is configured to be positioned upbeam of the plate and to compensate the attribute of aberration that will be generated by passage of the respective beams through the other plate. Alternatively, the electron-optical plate 60 may be positioned downbeam of the other plate and may be configured to correct the attribute of aberration that will be generated by passage of the respective beams through the other plate. The electron-optical plate 60 may compensate for one or more aberrations generated by another plate either upbeam or downbeam of it.

**FIG. 18** schematically shows a multipole of an electron-optical plate 60 with major surfaces parallel to the (110) plane of the crystal structure. The (110) plane has symmetry leading to a slightly rectangular (non-square or elongate) shape of the aperture 86B. In an embodiment the multipole comprises at least eight electrodes 76 for compensating for an attribute of aberration due to the rectangular shape.

**FIG. 19** schematically shows a multipole of an electron-optical plate 60 with major surfaces parallel to the (111) plane of the crystal structure. The (111) plane has symmetry leading to a slightly hexagonal shape of the aperture 86B. In an embodiment the multipole comprises at least twelve (12) electrodes 76 for compensating for an attribute of aberration due to the hexagonal shape.

In an embodiment the electrodes 76a are applied with an equal compensation potential. Similarly the electrodes 76b may be applied with an equal compensation potential. Different compensation potentials may be applied to the electrodes 76a compared to the electrodes 76b, for example as described with reference to and shown in **FIG. 17****,** except with an aperture having a slightly hexagonal shape, such as a hexagonally perturbed shape.

In an embodiment, a method of manufacturing an electron-optical plate 60 is provided. The plate 60 may take any of the forms described above with reference to **FIG. 9-19****.** The method comprises etching a channel 84 in each plate 60 of the plurality of plates 60. The etching process is such that apertures 86A, 86B defined at opposite ends of each channel 84 have different shapes.

In an embodiment the method comprises forming a plurality of channels 84 for beam paths of a plurality of beams through the substrate. The substrate has a crystalline structure with crystalline lines of symmetry. The channels 84 are between two major sides of the substrate.

In an embodiment the method comprises forming a plurality of multipoles associated with respective channels 84. Each multipole comprises a plurality of electrodes 76 for the associated channel. The electrodes are arranged such that lines of symmetry of the multipole are parallel to respective lines of symmetry of the crystalline structure of the substrate. In an embodiment forming the multipoles comprises positioning the electrodes 76 with respect to the channel 84 so that the geometrical lines of symmetry of the electrodes are parallel to respective crystalline lines of symmetry of the crystalline structure of the substrate.

In an embodiment the forming of the channels 84 comprises an etching process. For example, the etching process may comprise deep reactive-ion etching. Such an etching process may result in the apertures 86B being differently shaped from the corresponding apertures 86A on the other major surface of the substrate.

Although the preferred embodiment referred to an arrangement in which the beam paths are collimated, that need not always be the case; for example the beam paths may be diverging or converging (so as to be aligned with corresponding channels through the plates). Such an embodiment in a diverging path of the beam grid may comprise the plates of a condenser lens array 231 and/or a collimator 235 shown in a described with reference to **FIG. 3** and **FIG. 7****.** Such an embodiment in a converging path of the beam grid may comprise an image-forming element array 532 for example as shown in and described with reference to **FIG. 8****.** In a converging or diverging beam grid at least one of the beam paths is orthogonal to the plane of the plate. In an arrangement the beam paths may be controlled by electron-optical electrodes in one or more of the plates such as a multipole array in which surfaces of each of the channels and/or at least one of the associated apertures in the plate comprises a plurality of electrodes which may be controlled to deflect the paths of the beams relative to each other.

Although reference in this description is to a channel extending through the entire thickness of a plate, such a channel or a grid of channels may be comprised within a thinned region of the plate. For example one or both of the apertures of such a channel or of each of the channels in a grid may be defined in a recess in the surface of the plate; thus one or both major surfaces of the plate may be recessed.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g., voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, and the detector array 240. Such a voltage supply may be supplied respectively or commonly to different plates 60.

References to upper and lower, up and down, above and below, etc. should be understood as referring to directions parallel to the (typically but not always vertical) up-beam and down-beam directions of charged particle beams impinging on the sample 208. Thus, references to up beam and down beam are intended to refer to directions in respect of the beam path independently of any present gravitational field. The references to beam path are to the intended position of a corresponding beam during operation of the charged particle apertures. Such references when made in reference to an electron-optical element, such as an electrode plate, may be generally understood to relate, for a collimated beam path, to the optical axis of the beam and thus the orthogonal to the plane of the electron-optical element. In reference to an uncollimated beam, such as a divergent beam, the beam path may be considered to be relative to the axis of the mid-point of the beam, or the mid-point of beam grid when the beam is a beam of a beam grid. Therefore, although the orientation of the beam path may be considered an axis orthogonal to the plane of a planar electron-optical element, this may not always be the case; in some embodiments the beam path is angled (e.g., obliquely) relative to such a planar electron-optical element.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). It is appreciated that the invention may be applied to other types of apparatus such as a charged particle lithographic apparatus for use in generating patterns on a sample.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There are provided the following clauses:
Clause 1. A charged particle-optical plate for a charged particle-optical device for projecting charged particle beams along beam paths to a sample location, the charged particle-optical plate comprising: a substrate having a crystalline structure with crystalline lines of symmetry; a plurality of channels configured for passage of a plurality of beam paths of a beam grid through the substrate; and a plurality of multipoles associated with respective channels, each multipole comprising a plurality of electrodes for the associated channel, wherein the electrodes are arranged such that geometrical lines of symmetry of the multipole are parallel to respective crystalline lines of symmetry of the crystalline structure.
Clause 2. A charged particle-optical plate for a charged particle-optical device for projecting a charged particle beam along a beam path to a sample location, the charged particle-optical plate comprising: a substrate having a crystalline structure with crystalline lines of symmetry; a channel configured for a beam path of charged particles through the substrate; and a multipole associated with the channel, the multipole comprising a plurality of electrodes for the channel, wherein the electrodes are arranged such that geometrical lines of symmetry of the multipole are parallel to respective crystalline lines of symmetry of the crystalline structure.
Clause 3. The charged particle-optical plate of clause 1 or 2, wherein each channel has a diameter no greater than a thickness of the substrate through which the channel extends.
Clause 4. The charged particle-optical plate of any preceding clause, wherein the electrodes extend to define at least in part a channel wall, wherein desirably the channel wall defines the channel in a thickness direction of the substrate.
Clause 5. The charged particle-optical plate of clause 4, wherein each channel has a diameter no greater than an extent by which the electrodes extend along the channel wall in the thickness direction of the substrate.
Clause 6. The charged particle-optical plate of any preceding clause, wherein the substrate comprises opposing major surfaces connected by the channels and the channels terminate at apertures in the major surfaces, wherein desirably the substrate is planar, wherein the apertures at one of the major surfaces are shaped differently from the apertures at the other of the major surfaces.
Clause 7. The charged particle-optical plate of any preceding clause, wherein the channels and multipoles are arranged in an array and/or a grid, for example a two dimensional array, wherein desirably the grid has at least two axes.
Clause 8. The charged particle-optical plate of clause 7, wherein: the grid comprises at least three columns, optionally at least five columns; and/or the grid comprises at least three rows, optionally at least five rows,desirably wherein the columns extend in a direction corresponding to one of the at least two axes, desirably wherein the rows extend in a direction corresponding to one of the at least two axes.
Clause 9. The charged particle-optical plate of clause 7 or 8, wherein for at least one of the channels, an angle between a crystalline line of symmetry and an imaginary straight line connecting a centre of the channel and a centre of the grid and is greater than (Z/N)180° and less than ((Z+1)/N)180°, where Z is zero or a positive natural number and N is the number of electrodes of the multipole associated with the channel.
Clause 10. The charged particle-optical plate of any preceding clause, wherein each multipole comprises at least eight electrodes.
Clause 11. The charged particle-optical plate of any preceding clause, wherein each multipole has eight or 12 electrodes.
Clause 12. The charged particle-optical plate of any preceding clause, wherein the crystalline structure of the substrate has rotational symmetry of order four, two or six.
Clause 13. The charged particle-optical plate of any preceding clause, wherein the substrate comprises silicon.
Clause 14. The charged particle-optical plate of any preceding clause, wherein a plane of the substrate is parallel to a plane of the crystalline structure selected from a group consisting of a (100) plane, a (110) plane and a (111) plane.
Clause 15. The charged particle-optical plate of any preceding clause, comprising at least one electronic component comprising a plurality of layers electrically connected to at least one of the multipoles, wherein the plurality of layers are desirably a plurality of layers of circuitry, for example the at least one electronic component comprises CMOS circuity.
Clause 16. The charged particle-optical plate of clause, comprising a microelectromechanical component.
Clause 17. A charged particle-optical assembly comprising: the charged particle-optical plate of any preceding clause; and an electrical supply configured to apply electrical potentials to the electrodes.
Clause 18. The charged particle-optical assembly of clause 17 comprising: a controller configured to control the electrical supply to apply electrical potentials to the electrodes.
Clause 19. The charged particle-optical assembly of clause 18, wherein the controller is configured to control the electrical potentials applied to the electrodes so as to compensate for an attribute of aberration desirably being an electron-optical aberration in a beam grid comprising the plurality of beams and/or a respective beam of the plurality of beams.
Clause 20. The charged particle-optical assembly of clause 19, wherein the electron-optical aberration is associated with another plate of a stack comprising the charged particle-optical plate, wherein the other plate may be upbeam or downbeam of the charged particle-optical plate, the electrodes of a respective channel in the charged particle-optical plate may be configured to be controlled to compensate, e.g. correct or pre-compensate, the electron-optical aberration of the respective beam.
Clause 21. The charged particle-optical assembly of any of clauses 18-20, wherein the controller is configured to control the electrical potentials applied to the electrodes based on basic potentials and compensation potentials for compensation of an aberration of a respective electron-beam, e.g. correcting or pre-compensating the aberration
Clause 22. The charged particle-optical assembly of clause 21, wherein the compensation potentials of a plurality of the electrodes, for example of the plurality of multipoles of the grid or of an individual multipole of the grid, desirably all of the electrodes of an individual multipole, are equal.
Clause 23. The charged particle-optical assembly of clause 22, wherein the electrodes to which equal compensation potentials are applied form a formation that has an electrode rotational symmetry of order n, for example about an axis of the respective channel, and the crystalline structure of the substrate has a material rotational symmetry of order n, for example with respect to an axis in a direction orthogonal to the plane of the substrate, wherein desirably the geometrical lines of symmetry correspond to the electrode rotational symmetry, wherein desirably the crystalline structure of the substrate has crystalline lines of symmetry corresponding to the material rotational symmetry.
Clause 24. A charged particle-optical stack comprising: at least one of the charged particle-optical plate of any of clauses 1-16 or at least one of the charged particle-optical assembly of any of clauses 17-23.
Clause 25. The charged particle-optical stack of clause 24 comprising at least one other plate stacked relative to the charged particle-optical plate and/or at least one spacer for supporting and/or electrically isolating the at least one charged particle-optical plate, wherein desirably an individual spacer is between an individual charged particle-optical plate and an individual other plate.
Clause 26. The charged particle-optical stack of clause 25, wherein in the other plate is defined a plurality of channels comprising apertures with cross-sections which vary in shape along the respective channels, and the charged particle-optical plate is configured to correct an attribute of aberration generated in the plurality of channels of the other plate.
Clause 27. The charged particle-optical stack of clause 26, wherein the charged particle-optical plate is configured: to be positioned upbeam of the other plate and to pre-compensate the attribute of aberration that will be generated by passage of the respective beams through the other plate; or to be positioned downbeam of the other plate and to correct the attribute of aberration that will be generated by passage of the respective beams through the other plate.
Clause 28. A charged particle-optical module comprising at least one of the charged particle-optical plate of any of clauses 1-16, the charged particle-optical assembly of any of clauses 17-23 and the charged particle-optical stack of any of clauses 24 to 27
Clause 29. A charged particle-optical device for projecting charged particle beams along beam paths to a sample location, the charged particle-optical device comprising at least one of the charged particle-optical plate of any of clauses 1-16, the charged particle-optical assembly of any of clauses 17-23, the charged particle-optical stack of any of clauses 24-27 and the charged particle-optical module of clause 28.
Clause 30. A charged particle-optical apparatus comprising at least one of the charged particle-optical plate of any of clauses 1-16, the charged particle-optical assembly of any of clauses 17-23, the charged particle-optical stack of any of clauses 24-27, the charged particle-optical module of clause 28 and the charged particle-optical assembly of clause 29.
Clause 31. The charged particle-optical apparatus of clause 30, comprising an actuatable stage for supporting a sample at the sample location.
Clause 32. A method of manufacturing a charged particle-optical plate for a charged particle-optical device for projecting charged particle beams along beam paths to a sample location, the method comprising: providing a substrate having a crystalline structure; forming a plurality of channels for the beam paths through the substrate; and forming a plurality of multipoles associated with respective channels, each multipole comprising a plurality of electrodes for the associated channel, wherein the electrodes are arranged such that lines of symmetry of the multipole are parallel to respective lines of symmetry of the crystalline structure of the substrate.
Clause 33. A method of manufacturing a charged particle-optical plate for a charged particle-optical device for projecting charged particle beams along beam paths to a sample location, the method comprising: forming a plurality of channels for beam paths of a plurality of beams through a substrate having a crystalline structure with crystalline lines of symmetry, desirably between two major sides of the substrate; and forming a plurality of multipoles each associated with a respective channel, each multipole comprising a plurality of electrodes for the associated channel, the multipole having a geometrical lines of symmetry of the electrodes with respect to the channel, wherein the forming the multipoles comprises positioning the electrodes with respect to the channel so that that the geometrical lines of symmetry are parallel to respective crystalline lines of symmetry of the crystalline structure of the substrate.
Clause 34. The method of clause 32 or 33, wherein the forming of the channels comprises an etching process.
Clause 35. The method of clause 34, wherein the etching process comprises deep reactive-ion etching.
Clause 36. The method of any of clauses 32-35, optionally comprising providing the substrate, wherein providing the substrate comprises cutting a body having the crystalline structure along a plane parallel to a plane of the crystalline structure selected from a group consisting of a (100) plane, a (110) plane and a (111) plane.

## Claims

1. A charged particle-optical plate for a charged particle-optical device for projecting charged particle beams along beam paths to a sample location, the charged particle-optical plate comprising:
a substrate having a crystalline structure with crystalline lines of symmetry;
a plurality of channels configured for passage of a plurality of beam paths of a beam grid through the substrate; and
a plurality of multipoles associated with respective channels, each multipole comprising a plurality of electrodes for the associated channel, wherein the electrodes are arranged such that geometrical lines of symmetry of the multipole are parallel to respective crystalline lines of symmetry of the crystalline structure.

2. The charged particle-optical plate of claim 1, wherein each channel has a diameter no greater than a thickness of the substrate through which the channel extends.

3. The charged particle-optical plate of claim 1 or 2, wherein the electrodes extend to define at least in part a channel wall, wherein desirably the channel wall defines the channel in a thickness direction of the substrate.

4. The charged particle-optical plate of claim 3, wherein each channel has a diameter no greater than an extent by which the electrodes extend along the channel wall in the thickness direction of the substrate.

5. The charged particle-optical plate of any preceding claim, wherein the substrate comprises opposing major surfaces connected by the channels and the channels terminate at apertures in the major surfaces, wherein the apertures at one of the major surfaces are shaped differently from the apertures at the other of the major surfaces.

6. The charged particle-optical plate of any preceding claim, wherein the channels and multipoles are arranged in a grid, for example a two dimensional array, wherein desirably the grid has at least two axes.

7. The charged particle-optical plate of claim 6, wherein:
the grid comprises at least three columns; and/or
the grid comprises at least three rows,
wherein the columns extend in a direction corresponding to one of the at least two axes, and
wherein the rows extend in a direction corresponding to one of the at least two axes.

8. The charged particle-optical plate of claim 6 or 7, wherein for at least one of the channels, an angle between a crystalline line of symmetry and an imaginary straight line connecting a centre of the channel and a centre of the grid and is greater than (Z/N)180° and less than ((Z+1)/N)180°, where Z is zero or a positive natural number and N is the number of electrodes of the multipole associated with the channel.

9. The charged particle-optical plate of any preceding claim, wherein each multipole comprises at least eight electrodes.

10. The charged particle-optical plate of any preceding claim, wherein the crystalline structure of the substrate has rotational symmetry of order four, two or six.

11. The charged particle-optical plate of any preceding claim, wherein a plane of the substrate is parallel to a plane of the crystalline structure selected from a group consisting of a (100) plane, a (110) plane and a (111) plane.

12. The charged particle-optical plate of any preceding claim, comprising at least one electronic component comprising a plurality of layers electrically connected to at least one of the multipoles, wherein the plurality of layers are desirably a plurality of layers of circuitry, for example the at least one electronic component comprises CMOS circuity.

13. A charged particle-optical assembly comprising:
the charged particle-optical plate of any preceding claim; and
an electrical supply configured to apply electrical potentials to the electrodes.

14. The charged particle-optical assembly of claim 13 comprising:
a controller configured to control the electrical supply to apply electrical potentials to the electrodes. wherein the controller is configured to control the electrical potentials applied to the electrodes so as to compensate for an attribute of aberration desirably being an electron-optical aberration in a beam grid comprising the plurality of beams and/or a respective beam of the plurality of beams.

15. A method of manufacturing a charged particle-optical plate for a charged particle-optical device for projecting charged particle beams along beam paths to a sample location, the method comprising:
providing a substrate having a crystalline structure;
forming a plurality of channels for the beam paths through the substrate; and
forming a plurality of multipoles associated with respective channels, each multipole comprising a plurality of electrodes for the associated channel, wherein the electrodes are arranged such that lines of symmetry of the multipole are parallel to respective lines of symmetry of the crystalline structure of the substrate.
